Europäisches Patentamt

European Patent Office

Office européen des brevets

(11) Publication number: **0 098 175**
A2

# EUROPEAN PATENT APPLICATION

(21) Application number: 83303809.4

(22) Date of filing: 30.06.83

(51) Int. Cl.³: **H 01 L 23/48**
**H 01 L 21/60**
**//H01L23/04**

(30) Priority: 30.06.82 JP 112975/82

(43) Date of publication of application:
11.01.84 Bulletin 84/2

(84) Designated Contracting States:
CH DE FR GB LI NL SE

(71) Applicant: TOKYO SHIBAURA DENKI KABUSHIKI
KAISHA
72, Horikawa-cho Saiwai-ku
Kawasaki-shi Kanagawa-ken 210(JP)

(72) Inventor: Azuma, Makoto c/o Patent Division
TOKYO SHIB. DENKI K.K. 72, Horikawa-cho Saiwai-ku
Kawasaki-shi Kanagawa-ken Tokyo(JP)

(72) Inventor: Takigami, Katsuhiko c/o Patent Division
TOKYO SHIB. DENKI K.K. 72, Horikawa-cho Saiwai-ku
Kawasaki-shi Kanagawa-ken Tokyo(JP)

(74) Representative: Eyles, Christopher Thomas et al,
BATCHELLOR, KIRK & EYLES 2 Pear Tree Court
Farringdon Road
London, EC1R 0DS(GB)

(54) Pressure contact type semiconductor device.

(57) A pressure contact type semiconductor device such as a power transistor or a gate turn off thyristor is disclosed, which leads a current through a conductive member by application of a pressure thereto. The emitter or cathode of the device comprises a number of radially extending finger like island regions close together on the semiconductor substrate and radiate from a central part to a peripheral part thereof. The radial direction length of the semiconductor layers near the central part is less than that of those in the peripheral part, making the occurrence of cathode gate short circuits less likely.

FIG.5.

# PRESSURE CONTACT TYPE SEMICONDUCTOR DEVICE

## BACKGROUND OF THE INVENTION

This invention relates in general to the construction of semiconductor devices and in particular to high power devices of large size. More specifically, the invention relates to pressure contact type semiconductor devices such as a power transistor, a thyristor, a gate turn off (GTO) thyristor, etc., in which current flows through a conductive lead member in contact with an emitter or cathode of the semiconductor device by application of a pressure.

In a large current semiconductor device, such as for example, a power transistor or a GTO thyristor, the current of which reaches more than 100 A, its emitter or cathode is divided into a lot of small semiconductor regions. The reason for this is as follows. For the purpose of turning off a transistor or a GTO thyristor that is in an ON state, it is necessary to apply a negative bias to a base or gate thereof, so as to concentrate an ON state area from the boundary between the base or gate and an emitter or cathode to a central part thereof. Therefore, it is preferable for attaining an easy turn-off action to divide the emitter or cathode into a plurality of small island-like regions in order to shorten the distance from the boundary to the central part thereof.

For conducting a current from the emitter or cathode having such a plurality of small island-like regions, it is unsuitable to utilize a conventional wire-bonding arrangement that is normally used for small current semiconductor devices. It would be quite cumbersome to connect a lead wire to each island region. Therefore, to conduct current from all of the island regions, a pressure contact type electrode is normally used, which conducts current from an emitter or cathode by applying a pressure thereto and being in contact with all of the island regions.

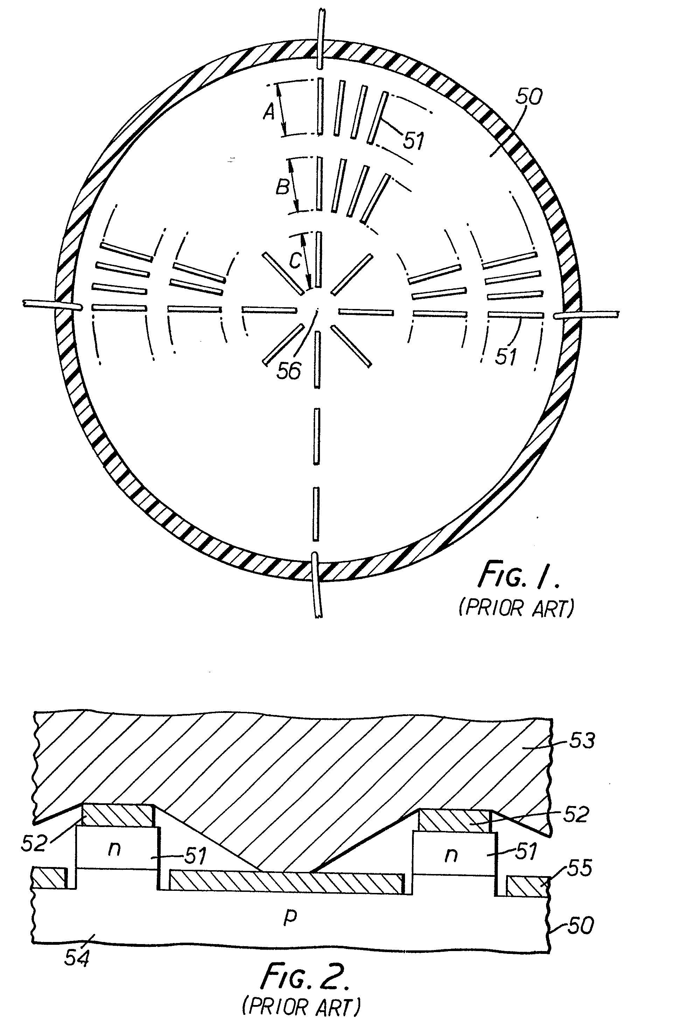

Referring to FIGURE 1, there is shown a top view of a known pressure contact type semiconductor device (this is a top view of the semiconductor substrate itself outside of its casing).

The plurality of small island-like regions 51 constituting the cathode of the device are arranged in concentric rings. Only a few regions in each ring are shown for clarity.

In known pressure contact type semiconductor devices, there arises the problem caused by a heat expansion coefficient difference between the pressure contact type electrode and the semiconductor materials constituting the semiconductor device. As the temperature of the device rises during its operation, the pressure contact type electrode, usually made of copper, expands more than the semiconductor material, usually silicon.

The emitter or cathode electrode layers, which are formed on the emitter or cathode, are relatively soft. Consequently, these electrode layers are likely to be pushed out and deformed in a tongue-like shape projecting from the small island-like regions of the emitter or cathode, and to cause a short circuit between the emitter or cathode and a base or gate electrode of the device. In order to decrease the likelihood of such a short circuit, a molybdenum plate is sandwiched between the main body of the pressure contact type copper electrode and the silicon semiconductor substrate, which has a heat expansion coefficient between that of the main body and that of the substrate.

In addition, as the semiconductor substrate 50 and the pressure contact type electrode (not shown in FIGURE 1) are normally disk-like, a slide friction therebetween is generated by heat expansion from a center to a periphery thereof.

In order to decrease projecting deformation of the emitter or cathode electrode layers caused by the slide friction, these electrode layers and the small island-like semiconductor layers therebeneath are shaped in a long and narrow rectangular form in a well-known device. These small emitter or cathode layers are separated from each other by grooves and are arranged as radiated from a central part 56 to a peripheral part of the semiconductor substrate with their long extending direction coincident with the radial direction thereof. The shape and size of each emitter or cathode layer is approximately the same considering simple designing.

Thus, the number of the small emitter or cathode layers adjacent to the central part of the substrate must be smaller than that in the peripheral part therof. Otherwise, it is impossible to arrange the layers separately each other on the substrate.

So, each angle defined by the adjacent emitter or cathode segments 51 is essentially large, and each interval between radial direction ends thereof, essentially wide. Thus, the pressure contact type electrode contacted to the emitter or cathode layers is likely to bend near the central part of the substrate by application of a pressure, and to cause a short accident between the emitter or cathode and the base or gate.

In the case that the pressure contact type electrode consists of a main body and a molybdenum plate contacting with the emitter or cathode electrode layers, the latter bends and thereby a short circuit accident is likely to occur.

Referring now to FIGURE 2 (prior art), there is shown a partial cross-section of the known pressure contact type semiconductor shown in FIGURE 1 (prior art). P layer 54 constituting a base of the semiconductor device is the uppermost semiconductor layer of the substrate. The N and P layers of substate 50 below P layer 54 are not shown in this figure. Gate electrode regions 15 are in contact with P layer 54. N regions 51 constitute a cathode of the semiconductor device. The cathode layer is divided into small, long and narrow rectangular island regions as shown in FIGURE 1 (prior art). Each of the regions of the cathode layer are covered by a cathode electrode region 52. A pressure-type electrode 53 makes contact with each of cathode electrode regions 52 so that electrical contact can be made with all of them via a copper cover.

The short circuit accident problem is illustrated in this figure. There is a tendency in the central portion of the substrate for pressure-type electrode 53 to deform and make short circuit contact with gate electrode regions 55.

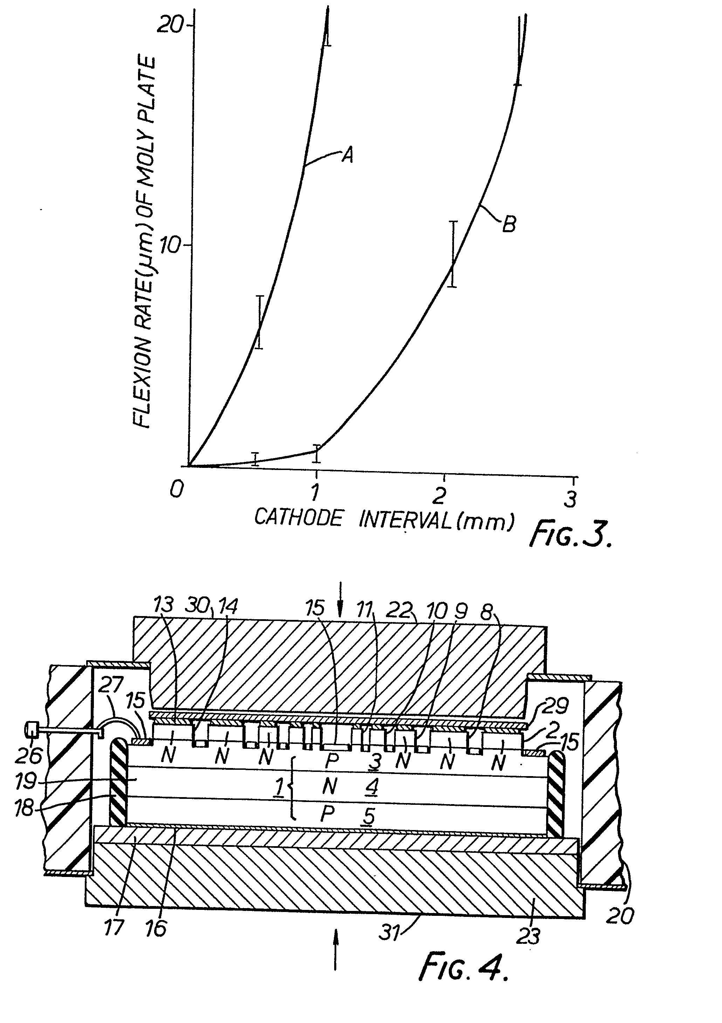

FIGURE 3 is a characteristic curve, which shows the relation between a cathode interval and a flexion rate of a molybdenum plate constituting a pressure contact type electrode in a gate turn off thyristor device. In this case, a 300 Kg/cm$^2$ pressure has been applied from the pressure contact type electrode to cathode electrode layers.

Each curve A, B shows an example, wherein the molybdenum plate has a 50 μm and a 200 μm thickness respectively. From these curves, one can understand that the flexion rate of the molybdenum plate increases according to the cathode interval, and that a contact accident of the cathode or gate electrodes is likely to occur, when grooves around cathode layers have a less than 20 μ m depth.

## SUMMARY OF THE INVENTION

Accordingly, this invention provides a novel structure for a pressure contact type semiconductor device which prevents a short accident between an emitter or cathode and a base or gate. This functional advantage is achieved by providing a contact type semiconductor device which comprises a semiconductor substrate including a first layer of one conductivity type, a layer of the opposite conductivity type and a second layer of the one conductivity type, an electrode formed on the first layer, and at least one conductive lead member contacting to the electrode by application of a pressure; the first layer including a lot of small long and narrow semiconductor layers formed closely together on a main surface of the substrate as separated from each other by grooves and radiated from a central part to a peripheral part of the substrate, and a radial direction length of the semiconductor layers near the central part being shorter than that in the peripheral part; and the electrode including small conductive layers formed on each semiconductor layer.

This device is highly suitable for a power bipolar transistor, wherein the first layer of the one conductivity type, the opposite conductivity type layer and the second layer of the one conductivity type constitute an emitter, a base and a cathode thereof respectively.

The present invention also provides a pressure contact type semiconductor device comprising: a semiconductor substrate including a first layer of one conductivity type, a first layer of the opposite conductivity type, a second layer of the one conductivity type and a second layer of the opposite conductivity type, an electrode formed on the first layer, and at least one conductive lead member contacting to the electrode by application of a pressure; the first layer of the one conductivity type including a lot of small long and narrow semiconductor layers formed closely together on a main surface of the substrate as separated from each other by grooves and radiated from a central part to a peripheral part of the substrate, and a radial direction length of the semiconductor layers near the central part being shorter than that in the peripheral part; and the electrode including small conductive layers formed on each semiconductor layer.

This device is suitable for a thyristor, especially a gate turn off type thyristor, wherein the substrate constitutes a thyristor, and the first layer of the one conductivity type being a cathode thereof.

In the above two types of pressure contact type semiconductor devices, the conductive lead member may comprise preferably a main body and a conductive plate sandwiched between the body and the electrode.

According to a preferable embodiment of the invention, the heat expansion coefficient of the main body is greater than that of the substrate, and at the same time that of the conductive plate being set between that of the body and that of the substrate. Thereby, decreases a tongue-like projecting deformation of the electrode on the first layer of the one conductivity type (an emitter or a cathode).

Coppers may be used as the main body. Silicons may be used as the substrate. A high melting point metal such as molybdenum or tungsten may be used as the conductive plate.

An allowable interval between the radial direction ends of the adjacent emitter or cathode layers is preferably under 5mm, when the conductive plate has a desirable thickness of 50-500 $\mu$ m. In the pressure contact type semiconductor device according to the invention, there is prevented efficiently a short accident of the emitter or cathode and the base or gate by flexion of the conductive lead member.

In addition, the device of the invention can increase an occupation rate of the emitter or cathode area near the central part of the semiconductor substrate in comparison with a conventional device. Thus, the device of the invention can decrease a current density and a heat resistance between the semiconductor substrate and the pressure contact type electrode, and thereby attain an efficient heat emission, a large average forward current, a low on-state voltage and a high surge current tolerance.

BRIEF DESCRIPTION OF THE DRAWINGS

The invention will be described in further detail with reference to the drawings wherein like reference numerals represent like or corresponding parts throughout, and wherein:

FIGURE 1 (prior art) is a top view of a known pressure contact type semiconductor device;

FIGURE 2 (prior art) is a partial cross-sectional view showing the problem attendant the known device shown in FIGURE 1;

FIGURE 3 is a characteristic curve which shows the relation between a cathode interval and a flexion rate of a molybdenum plate as a pressure contact type electrode in a gate turn off thyristor;

FIGURE 4 is a cross-sectional view of the device according to the preferred embodiment of the invention;

FIGURE 5 is a plane view of the device shown in FIGURE 4;

Figure 6 is a partial plan view of the device according to the present invention illustrating the spacing and sizes of the island regions; and

Figure 7 is a partial cross-sectional view of the present invention illustrating that the problem shown in Figure 2 is solved by the present invention.

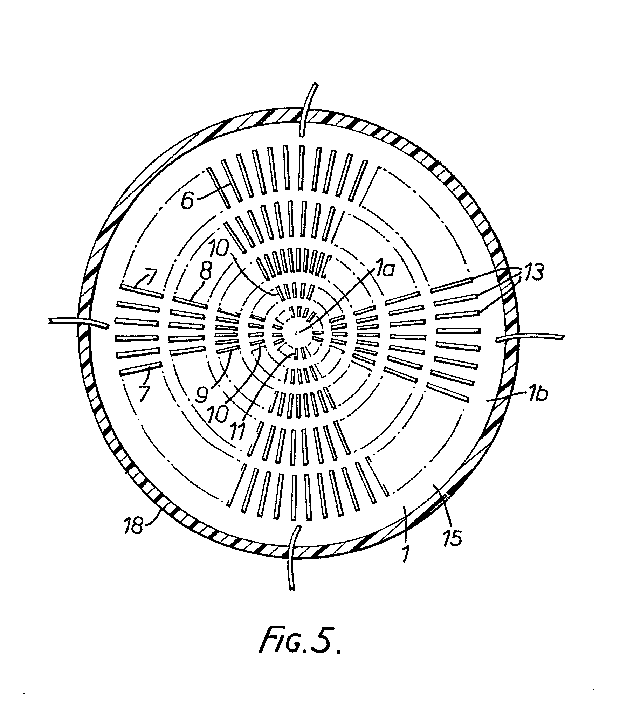

Figures 4 and 5 show an embodiment of the invention applied to a gate turn off thyristor, which will be described in detail. A silicon substrate 1 has a thyristor structure consisting of an N-type cathode layer 2, a P-type base layer 3, an N-type base layer 4 and a P-type anode layer 5.

The substrate 1 has a 40mm diameter and a 500 $\mu$m thickness. Cathode layer 2 has a 20 $\mu$m thickness and contains phosphorus of a $10^{20}$cm$^{-3}$ concentration. The P-type base layer 3 and anode layer 5, of a 50 $\mu$m thickness, contains borons of a $10^{17}$cm$^{-3}$ concentration. The N-type base layer 4 contains phosphorus of a $10^{14}$cm$^{-3}$ concentration.

The cathode layer 2 is divided into a plurality of small long and narrow rectangular semiconductor layers 6. These layers 6 are formed closely together on the substrate 1 and are arranged as radiated from a centre part 1a to a peripheral part 1b thereof and positioned respectively on five (5) circles of an identical centre and different diameters. The width of each semiconductor layer 6 is approximately 0.3 mm, and the length thereof is proportional to the distance from the centre of the substrate 1. That is, the semiconductor layers 7 on the most outside circle has a 3.5 mm length, the semiconductor segments 8 thereinside, a 2.5 mm length, the semiconductor segments 9 further thereinside, a 1.3 mm length, the semiconductor segments 10 thereinside, a 0.8 mm length, and the semiconductor layers 11 on the most inside circle having a 0.5 mm length. Each interval between the outward ends of the adjacent semiconductor layers 6 is about 0.45 mm. Each radial direction interval between the adjacent semiconductor layers 6 is about 0.5 mm.

On these semiconductor layers 6, there are formed cathode electrode layers 13 respectively. Furthermore, in grooves 14 thereamong, there is formed a gate electrode 15 of a 15μm thickness which contacts to the P-type base layer 3. An aluminum layer 16 of a 15 μm thickness is formed on the surface of the anode layer 5. Moreover thereon, a tungsten disk 17 is fixed through applying a pressure. These silicons of the substrate, aluminums and tungstens are alloyed through heat treatment. A side wall of the substrate 1 is surrounded by a silicon rubber 18.

The cathode layer 2, the P-type base layer 3 and the N-type base layer 4 constitute an NPN transistor, wherein the cathode operates as an emitter. The P-type base layer 3, the N-type base layer 4 and the anode layer 5 constitute a PNP transistor. The gate turn off thyristor 19 constituted in such a manner is set in a container 20. This container 20 comprises an insulator pipe 21 and copper posts 22, 23 of a 10-15 mm thickness, which are connected to each other by ring-like tungsten plates 24, 25. A non-reactive gas, such a nitrogen is introduced in the container 20. A gate terminal 26 is inserted through the insulator pipe 21 into the inside of the container 20, which is connected to the gate electrode 15 by a gate lead 27.

A molybdenum plate 29 of a 300 μm thickness is disposed between the post 22 and the cathode electrodes 13, which constitutes together with the post 22 a first conductive member 30 for current lead, i.e. a pressure contact type electrode. The post 23 constitutes a second conductive lead member 31 for current lead, i.e. a pressure contact type electrode. By pressing the metallic post 22, 23 against the semiconductor substrate 1, for example, under a 300 Kg/cm$^2$ pressure, the post 22 is electrically contacted through the molybdenum plate 29 to the cathode electrodes 13, and the other post 23, to the tungsten disk 17 as an anode electrode.

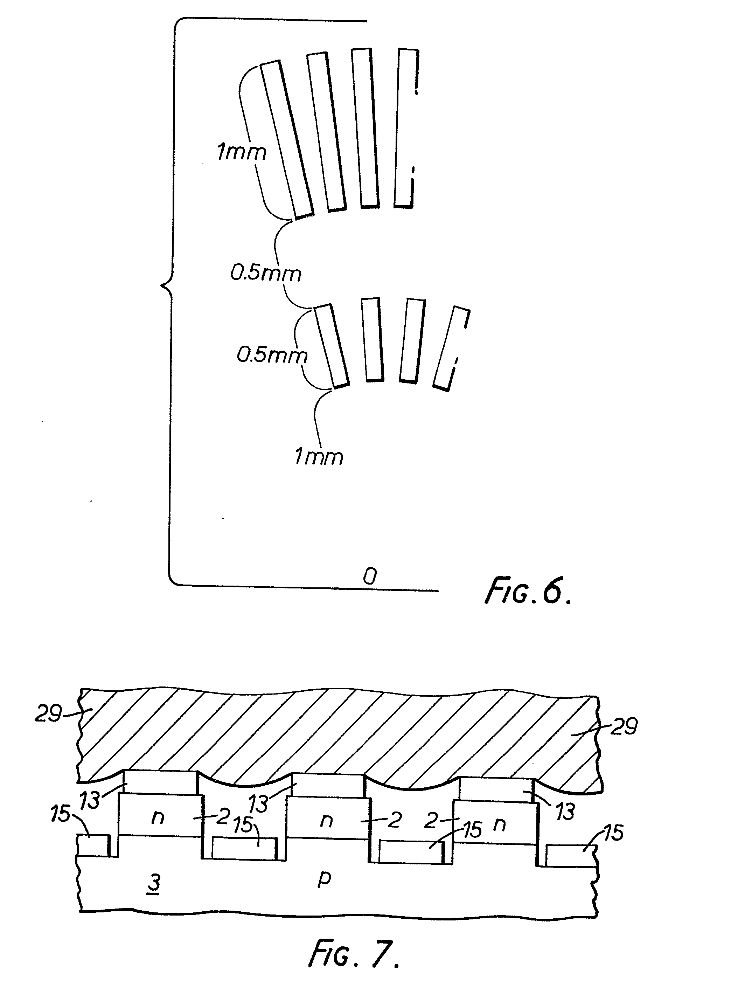

Referring now to FIGURE 6 there is shown a partial plan view of the device according to the present invention showing more precisely the size and spacing relationships among the island like regions.

Referring now to FIGURE 7 there is shown a partial cross-sectional view of the device according to the present invention. This figure is analogous to the FIGURE 2 partial cross-sectional view of the known device. Note that due to the use of shorter island regions toward the central portion of the substrate, the short circuit problem is solved.

In order to prove effectiveness of the invention, a pressure contact test has been performed using 20 pieces of gate turn off thyristor according to the above embodiment. As a result, any cathode-gate short accident has not been seen. On the other hand, cathode-gate short accidents have occurred with respect to 4 of 20 pieces of gate turn off thyristor having a conventional cathode pattern.

In addition, the thyristor according to the above-described embodiment has been able to attain a 20% higher forward current and a 15% lower voltage drop than thyristors of conventional design.

While the invention has been described in connection with what is presently considered to be the most practical and preferred embodiments, it is to be understood that the invention is not to be limited to the disclosed embodiments but on the contrary, is intended to cover various modifications and equivalent arrangements included within the spirit and scope of the appended claims which scope is to be accorded the broadest interpretation so as to encompass all such modifications and equivalent structures.

CLAIMS:

1.      A pressure contact type semiconductor device comprising:

a semiconductor substrate including a first layer of one conductivity type, a second layer of the opposite conductivity type, and a third layer of the one conductivity type, an electrode formed on the first layer, and at least one conductive lead member contacting the electrode by application of a pressure; the first layer being divided into a plurality of radially extending fingers, separated by grooves, each finger comprising a number of separate segments, and the length of the radially inner segments of each finger being less than the length of the radially outer segments, and the electrode including conductive layers formed on the said fingers.

2.      A pressure contact type semiconductor device according to claim 1, wherein the first layer of the one conductivity type, the second layer of opposite conductivity type layer and the third layer of the one conductivity type constitute an emitter, a base and a collector of a bipolar transistor respectively.

3.      A pressure contact type semiconductor device according to claim 1 further comprising a fourth layer of the said opposite conductivity type.

4.      A pressure contact type semiconductor device according to claim 3, wherein the substrate consitutes a thyristor, and the first layer of the one conductivity type comprises the cathode thereof.

5.      A pressure contact type semiconductor device according to claim 4, wherein the thyristor is a gate turn off thyristor.

6.      A pressure contact type semiconductor device
according to any preceding claim wherein the conductive lead
member comprises a main body and a conductive plate
sandwiched between the body and the electrode.

7.      A pressure contact type semiconductor device
according to claim 6, wherein the heat expansion coefficient
of the main body is greater than that of the substrate, the
expansion coefficient of the conductive plate being set
between that of the body and that of the substrate.

8.      A pressure contact type semiconductor device
according to claim 7, wherein the main body is made from a
material including copper, and the conductive plate is made
from a material including molybdenum.

9.      A pressure contact type semiconductor device
according to claim 1, wherein the circumferential spacing
between all the fingers is approximately the same.

10.      A pressure contact type semiconductor device,
comprising:
        a semiconductor substrate having a first top layer
of a first conductivity type and including a plurality of
island regions with grooves therebetween, said regions being
long and narrow, each being oriented radially from a central
axis of said substrate, said regions being organised in
groups forming concentric rings, the radial length of the
rings being least for the innermost ring near the central
axis and being greater for each successive ring toward the
peripheral portion of the substrate;
        a second layer of a second conductivity type
opposite said first conductivity type coupled to a bottom
portion of each region of said first layer and a third layer
of said first conductivity type coupled to a bottom portion of said second layer;

an electrode formed on said first layer, said electrode having a plurality of regions, one such electrode region formed on each region of said first substrate layer; and

a conductive member adapted to be in pressure contact with substantially all regions of said electrode.

0098175

1/4

FIG. 1.
(PRIOR ART)

FIG. 2.
(PRIOR ART)

2/4

FLEXION RATE (μm) OF MOLY PLATE

A

B

CATHODE INTERVAL (mm)

Fig. 3.

Fig. 4.

FIG.5.

FIG. 6.

FIG. 7.